# EUROPEAN PATENT APPLICATION

(11) **EP 3 392 904 A1**
(43) Date of publication of application: **24.10.2018**
(21) Application number: 16874862.2
(22) Date of filing: 15.12.2016
(51) Int. Cl.: H01L 21/67, H01L 21/56

(54) **CHIP-BONDING SYSTEM AND METHOD**

(30) Priority: 15.12.2015 CN 201510938394
(71) Applicant: Shanghai Micro Electronics Equipment (Group) Co., Ltd., Zhangjiang High-Tech Park Shanghai 201203 (CN)
(72) Inventor: CHEN, Yonghui, Shanghai 201203 (CN); TANG, Shiyi, Shanghai 201203 (CN); LI, Huili, Shanghai 201203 (CN)
(74) Representative: Lavoix
(86) International application number: PCT/CN2016/110057
(87) International publication number: WO 2017/101805

(57) **Abstract**

A die bonding system and a die bonding method are disclosed, in which dies (10) fed from a first motion stage (100) serving as a die source are re-arranged on a transfer tray (20) carried on a second motion stage (200) and bonded to a substrate (30) carried on a third motion stage (300). Pickup and transfer of the dies (10) between the three motion stages are accomplished by two motion mechanisms (010, 020) in such a manner that the dies (10) picked up from the first motion stage (100) are placed on the second motion stage (200) in an arrangement based upon a required final arrangement of them on the substrate (30). In other words, the dies (10) are re-arranged according to the required arrangement on the substrate (30). In this way, the need for re-arranging the dies after the transfer tray (20) is flipped and before they are bonded to the substrate is eliminated. Therefore, with the die bonding system, multiple dies 10 are allowed to be transferred simultaneously to the substrate based on the process requirements by flipping the mechanism for flipping the dies only once, which results in enhanced production efficiency and time savings and addresses the requirements for mass production.

## Description

### TECHNICAL FIELD

The present invention relates to the fabrication of semiconductor devices and, in particular, to a die bonding system and method.

### BACKGROUND

A flip-chip die bonding process is an interconnection approach for bonding a die to a submount which may be a substrate of silicon or another material. With the development of electronic products toward light weight, slimness and miniaturization, die bonding techniques are gaining increasing use. A die bonding process allows the fabrication of smaller packages with higher performance, when combined with a wafer-level packaging process. Moreover, a die bonding process in combination with a through-silicon via (TSV) process makes it possible to manufacture three-dimensional structures that are more competitive in terms of cost and performance.

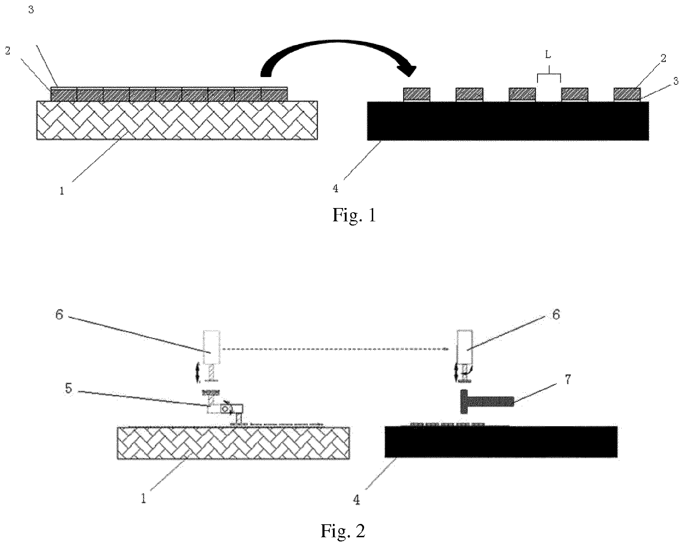

Referring to Fig. 1, in a conventional die flip-chip bonding apparatus, dies 2 to be bonded are carried on a support table 1 with their surface 3 where electronic components are formed facing upward. The dies 2 to be bonded are picked up and flipped by a mechanical arm and then bonded to a substrate 4. The pitch L of each die 2 is adjustable based on the requirements of various processes. Specifically, as shown in Fig. 2, a mechanical arm 5 picks up a die 2 on the support table 1, flips the die 2 and passes the die 2 on to another mechanical arm 6. The mechanical arm 6 then moves the die to above the substrate 4. After alignment is effected between an alignment mark on the surface of the die 2 to be bonded and a target alignment mark on the substrate 4 by using an image sensor 7, the die 2 is pressed down onto and thereby bonded to the substrate. This approach is, however, disadvantageous in that the whole process is carried out in a serial manner in which the dies are bonded consecutively one by one. In scenarios in which the pressing and bonding of each die takes a relatively long time and there are hundreds of dies to be bonded, each of the mechanical arms 5, 6 must repeat the operation for the same number of cycles, which is inefficient, time and power consuming and makes it impossible to meet the requirements for mass production.

In order to address the above problems, there is a need for a die bonding system and method with enhanced die bonding efficiency and suitable for mass production.

### SUMMARY OF THE INVENTION

In order to overcome the above-described problems, a die bonding apparatus and a die bonding method are proposed in the present invention, in which dies are transferred by two motion mechanisms between three motion stages configured respectively as a source for feeding the dies, for re-arrangement of the dies and for supporting a substrate to which the dies to be bonded. With the apparatus and method, multiple dies can be re-arranged, flipped and bonded to the substrate simultaneously in one pass, which reduces the required movement of the mechanical mechanism for flipping the dies, enhances production efficiency and addresses the requirements for mass production.

To this end, the present invention provides a die bonding system including: a first motion stage for feeding dies, a second motion stage for carrying a transfer tray and a third motion stage for supporting a substrate onto which the dies are to be bonded that are arranged in sequence; a first motion mechanism for picking up the dies from the first motion stage and placing the dies on the second motion stage; a second motion mechanism for picking up the transfer tray from the second motion stage and placing the transfer tray on the third motion stage; and a host system for controlling the die bonding system, wherein: the transfer tray is able to retain the dies; the second motion mechanism is able to flip the transfer tray; and the dies are ultimately bonded to the substrate.

Preferably, the die bonding system further includes detection systems each configured to detect a position of an object on a corresponding one of the first, second and third motion stages.

Preferably, the detection systems include a first alignment sub-system for aligning the first motion mechanism with the dies, a second alignment sub-system for causing the first motion mechanism to align the dies with the transfer tray and a third alignment sub-system for causing the second motion mechanism to align the transfer tray with the substrate, each of the first, second and third alignment sub-systems signal-connected to the host system.

Preferably, the die bonding system further includes a first motion stage control sub-system for controlling movement of the first motion stage, a second motion stage control sub-system for controlling movement of the second motion stage and a third motion stage control sub-system for controlling movement of the third motion stage, the first, second and third motion stage control sub-systems respectively signal-connected to the host system.

Preferably, the die bonding system further includes a first motion control sub-system for controlling the first motion mechanism and a second motion control sub-system for controlling the second motion mechanism, both the first and second motion control sub-systems signal-connected to the host system.

Preferably, the dies are adhesively retained on the first motion stage.

Preferably, the dies are retained on the transfer tray by electrostatic suction, vacuum suction or an organic adhesive.

Preferably, the substrate is fabricated from a metallic material, a semiconductor material or an organic material.

Preferably, the dies are bonded to the substrate adhesively or by means of thermal-press bonding.

Preferably, the transfer tray is provided with alignment marks serving as a reference for re-arrangement of the dies.

Preferably, the substrate is provided with arrangement marks corresponding to the alignment marks of the transfer tray, and wherein during the bonding of the dies on the transfer tray to the substrate, the alignment marks of the transfer tray and the arrangement marks of the substrate facilitate an alignment of the dies with the substrate.

The present invention also provides a die bonding method using the die bonding system as defined above, including the steps of:
1) retention of dies on the first motion stage and pickup of the dies by the first motion mechanism from the first motion stage;
2) placement and re-arrangement of the dies on the transfer tray on the second motion stage by the first motion mechanism;
3) pickup of the transfer tray from the second motion stage by the second motion mechanism;
4) flipping of the transfer tray by the second motion mechanism and bonding of the re-arranged dies on the transfer tray to the substrate; and
5) taking away the transfer tray by the second motion mechanism, which results in detachment of the dies from the transfer tray.

Preferably, the re-arrangement of the dies on the transfer tray is accomplished by rotating or moving the transfer tray by the second motion stage under a control of the host system each time when the first motion mechanism picks up one of the dies from the first motion stage, followed by placement of the picked die on a location of the transfer tray corresponding to the die by the first motion mechanism.

Compared to the prior art, the present invention has the following benefits: it provides a die bonding system including: a first motion stage for feeding dies, a second motion stage for carrying a transfer tray and a third motion stage for supporting a substrate onto which the dies are to be bonded that are arranged in sequence; a first motion mechanism for picking up the dies from the first motion stage and placing them on the second motion stage; a second motion mechanism for picking up the transfer tray from the second motion stage and placing it on the third motion stage; and a host system for controlling the die bonding system, wherein the transfer tray is able to retain the dies; the second motion mechanism is able to flip the transfer tray; and the dies are ultimately bonded to the substrate.

The invention also provides a die bonding method using the die bonding system as defined above, including the steps of:
1) retention of dies on the first motion stage and pickup of the dies by the first motion mechanism from the first motion stage;
2) placement and re-arrangement of the dies on the transfer tray on the second motion stage by the first motion mechanism;
3) pickup of the transfer tray from the second motion stage by the second motion mechanism;
4) flipping of the transfer tray by the second motion mechanism and bonding of the re-arranged dies on the transfer tray to the substrate; and
5) taking away the transfer tray by the second motion mechanism, which results in detachment of the dies from the transfer tray.

In the die bonding system and method provided in the present invention, the dies fed from the first motion stage serving as a die source are re-arranged on the transfer tray carried on the second motion stage and bonded to the substrate carried on the third motion stage. Pickup and transfer of the dies between the three motion stages are accomplished by the two motion mechanisms in such a manner that the dies picked up from the first motion stage are placed on the second motion stage in an arrangement based upon a required final arrangement of them on the substrate. In other words, the dies are re-arranged according to the required arrangement on the substrate. In this way, the need for re-arranging the dies after the transfer tray is flipped and before they are bonded to the substrate is eliminated. Therefore, with the die bonding system, multiple dies are allowed to be transferred simultaneously to the substrate in accordance with the process requirements by flipping the mechanism for flipping the dies only once, which results in enhanced production efficiency and time savings and addresses the requirements for mass production.

### BRIEF DESCRIPTION OF THE DRAWINGS

Figs. 1 and 2 are schematic illustrations of a conventional flip-chip die bonding process.
Fig. 3 is a structural schematic of a die bonding system provided in the present invention.
Fig. 4 is a structural schematic of a transfer tray provided in the present invention.

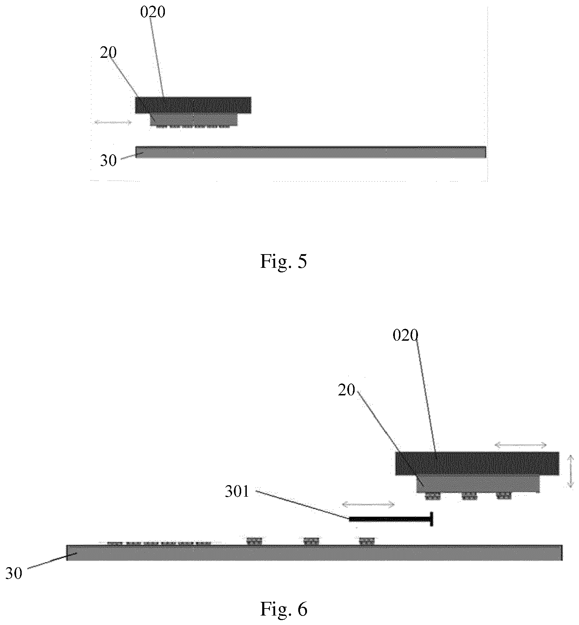

Figs. 5 and 6 both schematically illustrate how dies on the transfer tray are transferred to a substrate in accordance with the present invention.
Fig. 7 is a structural schematic of a substrate according to the present invention.

In the figures illustrating the conventional process: 1-support table; 2-bonding die; 3-surface where electronic components are formed; 4-substrate; 5-mechanical arm for flipping a die; 6-mechanical arm for transporting the die; 7-image sensor.

In the figures showing the present invention: 000-host system; 001-first motion stage control sub-system; 002-second motion stage control sub-system; 003-third motion stage control sub-system; 010-first motion mechanism; 011-first motion control sub-system; 020-second motion mechanism; 021-second motion control sub-system; 100-first motion stage; 101-first alignment sub-system; 200-second motion stage; 201-second alignment sub-system; 300-third motion stage; 301-third alignment sub-system; 10-die; 20-transfer tray; 21-alignment marks; 22-alignment area; 23-site for temporary bonding; 30-substrate; 31-bonding region.

### DETAILED DESCRIPTION

The above objectives, features, and advantages of the present invention will become more apparent and will be more readily understood upon reading the following detailed description of specific embodiments in conjunction with the accompanying drawings.

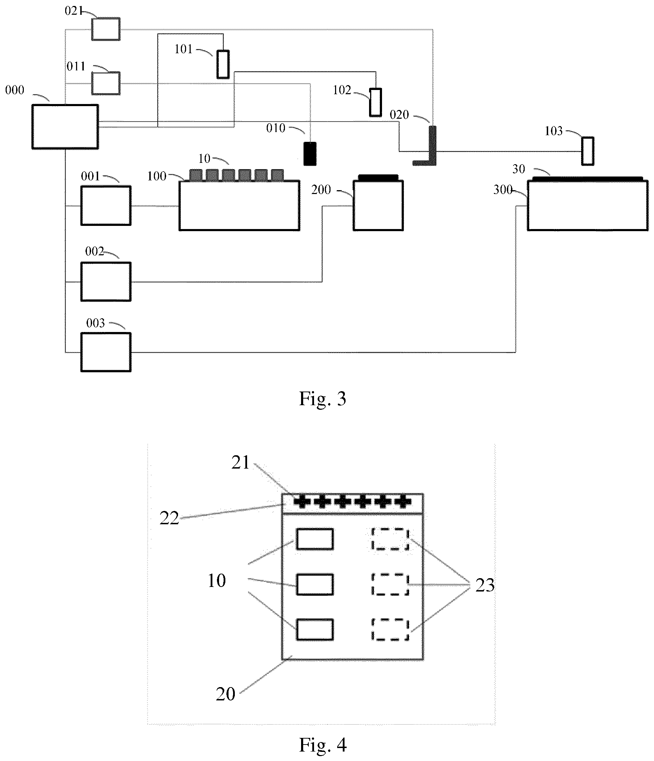

Referring to Fig. 3, a die bonding system provided in the present invention include: arranged in a sequence, a first motion stage 100 for feeding dies 10, a second motion stage 200 for carrying a transfer tray 20 and a third motion stage 300 for supporting a substrate 30 onto which the dies 10 are to be bonded; a first motion mechanism 010 for picking up a die 10 from the first motion stage 100 and placing it on the transfer tray 20 carried by the second motion stage 200; a second motion mechanism 020 for picking up the transfer tray 20 from the second motion stage 200 and placing it on the substrate 30 supported by the third motion stage 300; a first motion control sub-system 011 for controlling the first motion mechanism 010; a second motion control sub-system 021 for controlling the second motion mechanism 020; and a host system 000 for controlling the entire die bonding system. The host system 000 is signal-connected to a first motion stage control sub-system 001 capable of controlling the first motion stage 100, a second motion stage control sub-system 002 capable of controlling the second motion stage 200 and a third motion stage control sub-system 003 capable of controlling the third motion stage 300.

The die bonding system may further include a first alignment sub-system 101 for positional detection of the dies 10 on the first motion stage 100, a second alignment sub-system 201 for positional detection of the transfer tray 20 on the second motion stage 200 and a third alignment sub-system 301 for positional detection the dies 10 on the substrates 30 on the third motion stage 300. The first, second and third alignment sub-systems 101, 201, 301 are all under the direct control of the host system 000. In addition to the positional detection, the first, second and third alignment sub-systems 101, 201, 301 are also configured for detection of information about temperatures, pressures and the like of the respective motion stages.

The first, second and third motion stages 100, 200, 300 may be disposed in such a sequence that can facilitate movement of the first and second motion mechanisms 010, 020 while leaving enough rooms for the displacement or rotation of these motion stages.

The first motion stage 100 is configured to feed the dies 10, and the first motion stage 100 may be capable of movement in multiple degrees of freedom under the control of the first motion stage control sub-system 001. In general, the dies 10 may be bonded to a flexible organic adhesive material applied on the first motion stage 100. For example, the dies 10 may be bonded to an organic film. Alternatively, the dies 10 may be retained on a rigid material with die-limiting capabilities, which is carried on the first motion stage 100.

After the positional detection of the dies 10 on the first motion stage 100 is completed, the first alignment sub-system 101, that is disposed on the first motion stage 100, may transmit, to the host system 000, the detected positional information, based on which, the host system 000 may so control the first motion mechanism 010 via the first motion control sub-system 011 that accurate pickup of the dies 10 on the first motion stage 100 is made possible. For example, based on the type of the dies 10 to be picked up, the first alignment sub-system 101 may ascertain the positions and number of all the dies 10 on the first motion stage 100, based on which, the first motion mechanism 010 may, under the control of the first motion control sub-system 011, move to the position of a desired one of the dies 10 and pick it up.

The pickup of the die 10 by the first motion mechanism 010 may be accomplished by electrostatic or vacuum suction or the like. During the pickup of the die 10, the suction force on the die 10 is greater than the force by which the die 10 is retained on the first motion stage 100 so that smooth pickup of the die 10 is possible.

The transfer tray 20 is carried on the second motion stage 200, and the second motion stage 200 may be capable of movement in multiple degrees of freedom under the control of the second motion stage control sub-system 002. The dies 10 picked up by the first motion mechanism 010 from the first motion stage 100 may be placed on the transfer tray 20. Referring to Fig. 4, the distribution of the dies 10 on the transfer tray 20 differs from that on the first motion stage 100. An area of the transfer tray 20 for bearing the dies 10 may correspond to a mirror image of the whole or part of the substrate 30. As such, the dies 10 on the transfer tray 20 may be flipped by 180° and the distribution of the flipped dies 10 will be the same as the desired distribution on the substrate 30.

After a die 10 is picked up from the first motion stage 100 by the first motion mechanism 010, the second motion stage 200 may be rotated or displaced according to the distribution of the dies 10 on the transfer tray 20. During the rotation or displacement of the second motion stage 200, a target site of the transfer tray 20 on the second motion stage 200 for the placement of the die 10 is detected by the second alignment sub-system 201. After that, the first motion mechanism 010 may place the picked die 10 on the transfer tray 20 under the control of the host system 000.

The die 10 may be retained temporarily on the target site of the transfer tray 20 by electrostatic suction, vacuum suction or an organic adhesive. Upon the first motion mechanism 010 placing the die 10 on the target site of the transfer tray 20, the force by which the first motion mechanism 010 retains the die 10 may be instantaneously released so that the die 10 can be transferred to and retained on the transfer tray 20.

The transfer tray 20 may have an alignment area 22 in which there are alignment marks 21 serving as reference points for the sequential placement of the dies 10 by the first motion mechanism 010 on the transfer tray 20. To this end, the second alignment sub-system 201 may inform the host system 000 of the target positions of the dies 10 relative to the alignment marks 21, based on which the first motion mechanism 010 may place the dies 10 onto the transfer tray 20 under the control of the host system 000.

The second motion mechanism 020 may hold the transfer tray 20, optionally at the opposing edges of the transfer tray 20, by means of vacuum suction, electrostatic suction or mechanically. The second motion mechanism 020 may be able to flip the transfer tray 20 by 180° so that the dies 10 on the transfer tray 20 can be bonded to the substrate 30.

Preferably, the substrate 30 may be formed of a metallic material, a semiconductor material or an organic material.

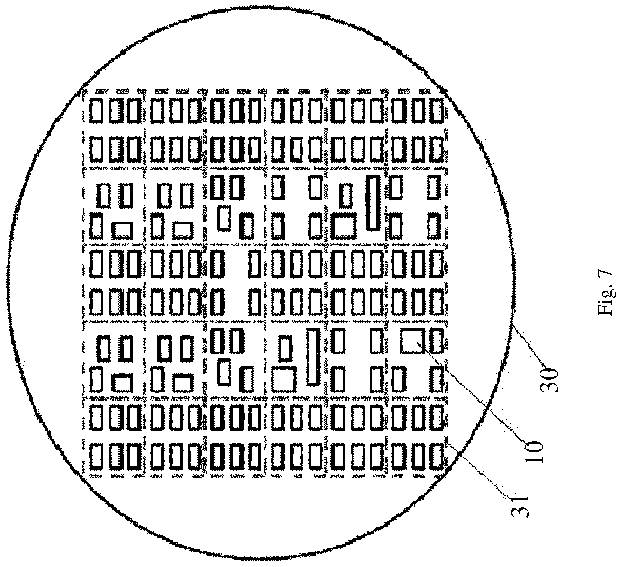

Referring to Fig. 7, the substrate 30 may be provided with arrangement marks (not shown) in respective correspondence with the alignment marks 21. After the transfer tray 20 is flipped by the second motion mechanism 020, the third alignment sub-system 301 may perform a positional detection of the arrangement marks on the substrate 30 and the alignment marks 21 on the transfer tray 20. Then, the third motion stage 300 is controlled by the third motion stage control sub-system 003 and the second motion mechanism 020 is controlled by the second motion control sub-system 021, such that the transfer tray 20 is displaced and rotated caused by the second motion mechanism 020, and the third motion stage 300 is displaced and moved by the third motion stage control sub-system 003, so as to achieve an alignment between the alignment marks 21 and the arrangement marks. Afterwards, the dies on the transfer tray 20 can be bonded with the substrate 30. As a result, the dies 10 may be bonded to the respective target sites for the dies 10 on the substrate 30.

With continued reference to Fig. 7, the substrate 30 may be demarcated into a number of bonding regions 31. An area of the transfer tray 20 for bearing the dies 10 may have the same size as a bonding region 31 for bearing the dies 10. Every time the second motion mechanism 020 transports the transfer tray 20 to the substrate 30, the die bonding of a target one of the bonding regions 31 will be achieved.

Preferably, the dies 10 may be bonded to the substrate 30 by an adhesive or by pressing them down onto the substrate 30 by the second motion mechanism 020 while heating the substrate 30 by the third motion stage 300, such that the dies 10 may be thermal-press bonded to the substrate 30.

The present invention also provides a die bonding method employing the die bonding system as defined above, which specifically includes the steps as detailed below.

In Step 1, a number of dies 10 are adhesively bonded to the first motion stage 100. The dies 10 may optionally have different types and the types and number thereof may be based on the requirements on the dies 10 to be ultimately bonded to the substrate 30.

In Step 2, the first motion mechanism 010 moves into the vicinity of the first motion stage 100 under the control of the first motion control sub-system 011 which is dictated by the host system 000. The first alignment sub-system 101 then detects the position of a target die 10 to be picked up from the first motion stage 100 and transfers information about the position to the host system 000. Based on the positional information detected by the first alignment sub-system 101, the host system 000 issues a signal to the first motion control sub-system 011, which dictates the first motion control sub-system 011 to so control the first motion mechanism 010 that the latter picks up the target die 10 from the first motion stage 100. In this process, in order for adjustments in the way the die 10 is picked up to be achieved, the first motion stage 100 may be displaced or rotated under the control of the first motion stage control sub-system 001 or the first motion mechanism 010 may be forced to move.

In Step 3, a target one of the bonding regions 31 of the substrate 30 to which the dies are to be transferred from the transfer tray 20 on the second motion stage 200 is first determined. Then, an arrangement pattern on the transfer tray 20 which corresponds to a mirror image of a desired arrangement pattern of the dies in the bonding region 31 is determined. After that, the positions and arrangement of the dies 10 to be temporarily bonded are determined. Upon the first motion mechanism 010 picking up a die 10 from the first motion stage 100, the die 10 moves into the vicinity of the second motion stage 200. The second alignment sub-system 201 detects a target site 23 of the transfer tray 20 to which the die 10 is to be temporarily bonded and informs the host system 000 of the detected target site, based on which, the host system 000 dictates the second motion control sub-system 021 to cause movement of the second motion mechanism 020, and the host system 000 dictates the second motion stage control sub-system 002 to cause displacement or rotation of the second motion stage 200. Preferably, the movement of the first motion mechanism 010 is based on the alignment marks 21 in the alignment area 22 of the transfer tray 20, while the displacement or rotation of the second motion stage 200 is based on the way the die 10 to be temporarily bonded to the transfer tray 20. Following the completion of the displacement or rotation of the second motion stage 200, the host system 000 dictates the first motion control sub-system 011 to cause the first motion mechanism 010 to place the die 10 onto the target site of the transfer tray 20 to which the die 10 is to be temporarily bonded. During the placement, the transfer tray 20 may exert a temporarily bonding force on the die 10 that is greater than the force by which the die 10 is retained on the first motion mechanism 010, and the second alignment sub-system 201 may perform a detection process for ensuring the positional accuracy of the placement.

In Step 4, after a desired number of dies 10 are temporarily bonded to the transfer tray 20, the host system 000 dictates the second motion control sub-system 021 to cause the second motion mechanism 020 to clamp opposite edges of the transfer tray 20 and moves it into the vicinity of the third motion stage 300. The third alignment sub-system 301 then detects the position of the target bonding region 31 of the substrate 30 to which the dies are to be bonded, and the second motion mechanism 020 moves the transfer tray 20 into the vicinity of the bonding region 31. Alternatively, the third motion stage 300 may move in coordination with the second motion mechanism 020 so that the transfer tray 20 carried on the second motion mechanism 020 is located above the target bonding region 31. The transfer tray 20 on which the dies 10 are bonded in a manner desired by the bonding region 31 is flipped by 180° and moved downward by the second motion mechanism 020 to approach the bonding region 31. Upon the dies 10 on the transfer tray 20 coming into contact with the substrate 30, the force by which the dies 10 are retained on the transfer tray 20 is instantaneously released, or the substrate 30 provides an attractive force on the dies 10 that is greater than the retention force on the dies 10 from the transfer tray 20 so that the dies 10 are transferred to and retained on the substrate 30. At this point, the transfer tray 20 may be caused to move away from the dies 10 as required by the process, leaving the dies 10 bonded to the substrate 30. Alternatively, if thermal-press bonding of the dies 10 to the substrate 30 is further required, then the transfer tray 20 may exert a downward pressure on the dies 10, concurrently with the third motion stage 300 heating the substrate 30 to make the dies 10 thermal-press bonded to the substrate 30.

According to the present invention, it is possible to either first temporarily bond all dies 10 for a target bonding region 31 of the substrate 30 to the transfer tray 20 and then transfer them all at once from the transfer tray 20 to the bonding region 31 or transfer them to the bonding region 31 one by one with the transfer tray 20 acting as a temporary transit. In the former case, it is necessary to make all the dies 10 temporarily bonded to the transfer tray 20 flush at their top surfaces so as to ensure each of the dies 10 can come into contact with the substrate 30 during the downward movement of the transfer tray 20 after it is flipped by 180°.

The die bonding system and method provided in the present invention allow multiple dies 10 to be transferred simultaneously to the substrate 30 based on the process requirements by flipping the second motion mechanism 020 only once, which results in enhanced production efficiency and time savings and addresses the requirements for mass production.

It is apparent that those skilled in the art can make various modifications and variations to the present invention without departing from the spirit and scope thereof. Accordingly, it is intended that all such modifications and variations are embraced in the scope of the invention if they fall within the scope of the appended claims and their equivalents.

## Claims

1. A die bonding system, comprising: a first motion stage for feeding dies, a second motion stage for carrying a transfer tray and a third motion stage for supporting a substrate onto which the dies are to be bonded that are arranged in sequence; a first motion mechanism for picking up the dies from the first motion stage and placing the dies on the second motion stage; a second motion mechanism for picking up the transfer tray from the second motion stage and placing the transfer tray on the third motion stage; and a host system for controlling the die bonding system, wherein: the transfer tray is able to retain the dies; the second motion mechanism is able to flip the transfer tray; and the dies are ultimately bonded to the substrate.

2. The die bonding system of claim 1, further comprising detection systems each configured to detect a position of an object on a corresponding one of the first, second and third motion stages.

3. The die bonding system of claim 2, wherein the detection systems comprise a first alignment sub-system for aligning the first motion mechanism with the dies, a second alignment sub-system for causing the first motion mechanism to align the dies with the transfer tray and a third alignment sub-system for causing the second motion mechanism to align the transfer tray with the substrate, each of the first, second and third alignment sub-systems signal-connected to the host system.

4. The die bonding system of claim 1, further comprising a first motion stage control sub-system for controlling movement of the first motion stage, a second motion stage control sub-system for controlling movement of the second motion stage and a third motion stage control sub-system for controlling movement of the third motion stage, the first, second and third motion stage control sub-systems respectively signal-connected to the host system.

5. The die bonding system of claim 1, further comprising a first motion control sub-system for controlling the first motion mechanism and a second motion control sub-system for controlling the second motion mechanism, both the first and second motion control sub-systems signal-connected to the host system.

6. The die bonding system of claim 1, wherein the dies are adhesively retained on the first motion stage.

7. The die bonding system of claim 1, wherein the dies are retained on the transfer tray by electrostatic suction, vacuum suction or an organic adhesive.

8. The die bonding system of claim 1, wherein the substrate is fabricated from a metallic material, a semiconductor material or an organic material.

9. The die bonding system of claim 1, wherein the dies are bonded to the substrate adhesively or by thermal-press bonding.

10. The die bonding system of claim 1, wherein the transfer tray is provided with alignment marks serving as a reference for re-arrangement of the dies.

11. The die bonding system of claim 10, wherein the substrate is provided with arrangement marks corresponding to the alignment marks of the transfer tray, and wherein during the bonding of the dies on the transfer tray to the substrate, the alignment marks of the transfer tray and the arrangement marks of the substrate facilitate an alignment of the dies with the substrate.

12. A die bonding method using the die bonding system as defined in any one of claims 1 to 11, comprising the steps of:
1) retention of dies on the first motion stage and pickup of the dies by the first motion mechanism from the first motion stage;
2) placement and re-arrangement of the dies on the transfer tray on the second motion stage by the first motion mechanism;
3) pickup of the transfer tray from the second motion stage by the second motion mechanism;
4) flipping of the transfer tray by the second motion mechanism and bonding of the re-arranged dies on the transfer tray to the substrate; and
5) taking away the transfer tray by the second motion mechanism, which results in detachment of the dies from the transfer tray.

13. The die bonding method of claim 12, wherein the re-arrangement of the dies on the transfer tray is accomplished by rotating or moving the transfer tray by the second motion stage under a control of the host system each time when the first motion mechanism picks up one of the dies from the first motion stage, followed by placement of the picked die on a location of the transfer tray corresponding to the die by the first motion mechanism.
